# EUROPEAN PATENT SPECIFICATION

(11) **EP 4 558 768 B1**
(45) Date of publication and mention of the grant of the patent: **16.09.2026**
(21) Application number: 23752133.1
(22) Date of filing: 13.07.2023
(51) Int. Cl.: H10P 72/30, H10P 72/00, B23K 3/047, B23K 1/00, G01J 5/00, G01J 5/53, G01J 5/52, F27D 21/00, F27B 9/40, B23K 1/008

(54) **PROCESSING FURNACE**
BEARBEITUNGSOFEN
FOUR DE TRAITEMENT

(30) Priority: 21.07.2022 CN 202210862106
(43) Date of publication of application: 28.05.2025
(73) Proprietor: Illinois Tool Works, Inc., Glenview, Illinois 60025 (US)
(72) Inventor: CHEN, Yuexin, Glenview, Illinois 60025 (US); WEI, De, Glenview, Illinois 60025 (US)
(74) Representative: HGF
(86) International application number: PCT/US2023/070138
(87) International publication number: WO 2024/020313

(56) References cited:
- US-A1- 2006 081 598
- US-A1- 2019 219 450
- US-A1- 2020 141 809
- US-A1- 2022 181 177

## Description

### Technical Field

The present application relates to a processing furnace, particularly to a processing furnace comprising an infrared temperature measurement device.

### Background

In some furnaces there are a plurality of processing zones, including a heating zone and a cooling zone, where the processed component absorbs heat in the heating zone and cold in the cooling zone for the completion of various processing steps. For example, photovoltaic components such as silicon wafers for crystalline silicon solar cells are sintered in a sintering furnace and circuit boards are soldered in a reflow soldering furnace to solder electronic components to the circuit boards. In these furnaces, the amount of heat or cold absorbed by the processed component needs to be accurately controlled.

US2022181177A1 discloses an apparatus configured to join electronic components to an electronic substrate, where the apparatus includes at least one temperature sensor configured to detect temperatures of the electronic substrates passing proximate to the at least one temperature sensor. A controller is coupled to the heat detection system and receives temperature data from the heat detection system.

US2006081598A1 discloses a portable blackbody furnace that can be used for temperature calibration of a radiation thermometer. Further prior art is disclosed in US2019219450 A1 and US2020141809 A1.

### Summary

At least one object of the present application is to provide a reflow soldering furnace comprising a furnace chamber; at least one infrared temperature measurement device that is connected to the furnace chamber and configured to have a detection field of view toward the furnace chamber; at least one calibration device that is provided corresponding to the at least one temperature measurement device and is connected to the furnace chamber, with the calibration device comprising a black body module having a standard temperature that is connected to the detection field of view of the corresponding infrared temperature measurement device and is capable of providing standard temperature data; and a controller that is communicatively connected to the infrared temperature measurement device and the calibration device; wherein the infrared temperature measurement device is configured to be capable of detecting the temperature of the black body module in the corresponding calibration device and obtaining calibration temperature data, and the controller is configured to calibrate the infrared temperature measurement device according to the standard temperature data and the calibration temperature data.

According to the above, the furnace chamber comprises a plurality of processing zones; the reflow soldering furnace further comprises a conveying device disposed within the furnace chamber and extending in the conveying direction, with the conveying device configured to carry the processed component (circuit board) through the plurality of processing zones of the furnace chamber; the infrared temperature measurement device is configured to detect the temperature of the processed component (circuit board) in the furnace chamber and provide detected temperature data; wherein the controller is configured to receive the detected temperature data provided by the infrared temperature measurement device.

According to the above, the at least one infrared temperature measurement device comprises a plurality of infrared temperature measurement devices configured to detect the temperature of the processed component (circuit board) at two or more independent locations in the plurality of processing zones in the furnace chamber.

According to the above, the furnace chamber comprises an upper furnace chamber and a lower furnace chamber, and the conveying device extends between the upper furnace chamber and the lower furnace chamber, wherein the black body module is connected to the top of the lower furnace chamber.

According to the above, the plurality of processing zones comprises a plurality of processing units arranged side by side, with the black body module connected between two adjacent processing units of the plurality of processing units.

According to the above, the calibration device further comprises a temperature sensor configured to provide the standard temperature of the black body module.

According to the above, the temperature sensor is a resistance temperature detector.

According to the above, the calibration device further comprises a heating module and a cooling module, wherein the heating module is configured to increase the temperature of the black body module and the cooling module is configured to reduce the temperature of the black body module.

According to the above, the black body module comprises a cooling gas channel with a tortuous shape that is fluidly connected with the cooling module, wherein the cooling module is configured such that cooling gas flows through the cooling gas channel to reduce the temperature of the black body module.

According to the above, the top wall of the furnace chamber has at least one furnace chamber top opening; each of the infrared temperature measurement devices comprises an infrared camera and a support shroud, with the infrared camera mounted to the support shroud; wherein the support shroud encircles the furnace chamber top opening and is supported on the top wall to provide the detection field of view toward the inside of the furnace chamber through the corresponding furnace chamber top opening.

Other objects and advantages of the present application will be apparent from the description of the present application hereinafter with reference to the attached drawings, and may help with a comprehensive understanding of the present application.

### Brief Description of the Drawings

Fig. 1 is a schematic diagram of a processing furnace according to an example of the present application;
Fig. 2A is a partial three-dimensional structural diagram of the processing furnace shown in Fig. 1;
Fig. 2B is a top view of the processing furnace shown in Fig. 2A;
Fig. 2C is a cross-sectional view of the processing furnace shown in Fig. 2B along line A-A;
Fig. 2D is a three-dimensional structural diagram of the processing furnace shown in Fig. 2A after omitting the upper furnace;
Fig. 3A is a three-dimensional structural diagram of the calibration device in Fig. 2A;
Fig. 3B is a three-dimensional structural diagram of the black body module in Fig. 3A;
Fig. 3C is a longitudinal cross-sectional view of the black body module in Fig. 3B;
Fig. 3D is a transverse cross-sectional view of the black body module in Fig. 3B;
Fig. 4 is a structural diagram of a controller according to an example of the present application.

### Detailed Description

Various specific embodiments of the present application will be described below with reference to the attached drawings that constitute a part of the present Specification. It should be understood that while terms denoting orientation, such as "front," "rear," "upper," "lower," "left," "right," "top," "bottom," "inside," "outside," etc., are used in the present application to describe various exemplary structural parts and elements of the present application, these terms are used herein for convenience of illustration only and are determined based on the exemplary orientations shown in the attached drawings. Since the examples disclosed in the present application may be disposed in different orientations, these terms denoting orientation are for illustrative purposes only and should not be considered as limiting.

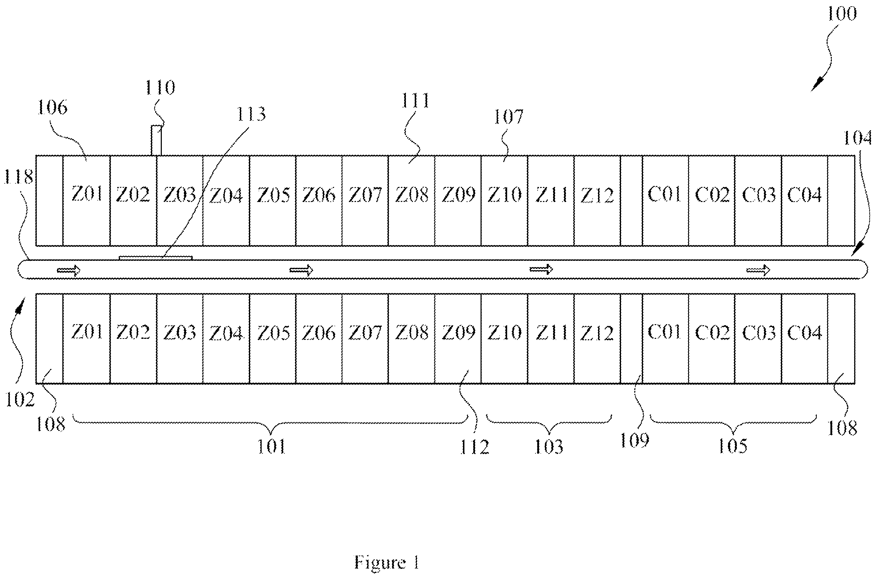

Fig. 1 is a schematic diagram of the principle of a processing furnace 100 according to an example of the present application, for illustrating the processing process of a processed component 113 by the processing furnace 100 on. In the present example, the processing furnace 100 is a reflow soldering furnace and the processed component 113 is a circuit board to be soldered. As shown in Fig. 1, the reflow soldering furnace comprises a furnace chamber 106 and a plurality of processing zones disposed in the furnace chamber 106, wherein the plurality of processing zones comprise a preheating zone 101, a peak zone 103, and a cooling zone 105. The preheating zone 101, the peak zone 103, and the cooling zone 105 are arranged side by side along the length of the furnace chamber 106. The furnace chamber 106 comprises an upper furnace chamber 111 and a lower furnace chamber 112 disposed opposite to each other. The reflux furnace further comprises a conveying device 118 disposed between the upper furnace chamber 111 and the lower furnace chamber 112 in the furnace chamber 106 and extending along the conveying direction. The conveying device 118 is used to carry the processed component 113 from the inlet 102 at the left end of the furnace chamber 106 into the furnace chamber 106, successively through the preheating zone 101, the peak zone 103 and the cooling zone 105 in the conveying direction, and then out of the furnace chamber 106 through the outlet 104 at the right end of the furnace chamber 106, such as in the completion of the soldering process of a circuit board to be soldered.

In particular, heating elements are provided in the preheating zone 101 and the peak zone 103, respectively, to enable gas in the preheating zone 101 and the peak zone 103 to be heated. In the example as shown in Fig. 1, the preheating zone 101 includes nine processing units 107, i.e. the heating units Z01 - Z09 in Fig. 1. The peak zone 103 comprises three processing units 107, i.e. the heating units Z10 - Z12 in Fig. 1. These processing units 107 (i.e., heating units Z01 - Z12) are arranged side by side in the furnace chamber 106 along the length of the furnace chamber 106. The heating units Z01 - Z09 and heating units Z10 - Z12 are connected in succession and gradually increase in temperature. These heating units are arranged sequentially by serial number, e.g., heating units Z10 and Z12 are located on both sides of the heating unit Z11, with the heating unit Z10 between the heating unit Z09 and the heating unit Z11. After the circuit board to be soldered is fed into the preheating zone 101, the circuit board is heated and a portion of the flux in the solder paste dispensed on the circuit board vaporizes. Since the temperature of the peak zone 103 is higher than that of the preheating zone 101, the solder paste will melt completely in the peak zone 103 when the circuit board is delivered to the peak zone 103. The peak zone 103 is also a region where higher temperature VOCs (e.g., pine sap and resin in the flux) will vaporize.

A cooling element is provided in the cooling zone 105 to enable gas in the cooling zone 105 to be cooled. In the example shown in Fig. 1, the cooling zone 105 comprises four processing units 107, i.e., cooling units C01 - C04, which are arranged side by side in the furnace chamber 106 along the length of the furnace chamber 106. In the present example, the cooling units CO1 - C04 are connected in succession, i.e., these cooling units are arranged sequentially by serial number and gradually increase in temperature. This means that the temperature of the gas in the heating units Z01 - Z12 gradually increases and the temperature of the gas in the cooling units C01 - C04 gradually decreases in the conveying direction of the reflow soldering furnace. After the circuit board is transported from the peak zone 103 into the cooling zone 105, the solder paste is cooled on the circuit board and cured into solder joints, thus securing the electronic components to the circuit board. Notably, the number of processing units in the preheating zone 101, peak zone 103 and cooling zone 105 of the reflow soldering furnace may be varied depending on the product to be soldered and the different soldering processes, and is not limited to the example shown in Fig. 1.

The reflow soldering furnace further comprises a pair of barrier boxes 108 disposed at the inlet 102 and outlet 104 of the furnace chamber 106, that is, the outside of the preheating zone 101 and the cooling zone 105. When the reflow soldering furnace uses an inert gas (e.g., nitrogen) as the working gas, a pair of barrier boxes 108 are used to prevent the preheating zone 101 and cooling zone 105 in the furnace chamber 106 from being connected to the outside environment to prevent air in the external environment from affecting the soldering quality.

The reflow soldering furnace further comprises a barrier exhaust zone 109 disposed between the peak zone 103 and the cooling zone 105. The barrier exhaust zone 109 may draw or exhaust gas from the furnace chamber 106, thereby hindering or reducing the flow of gas containing volatile contaminants from the peak zone 103 to the cooling zone 105, and serving as an insulation zone that separates the high-temperature peak zone 103 from the low-temperature cooling zone 105.

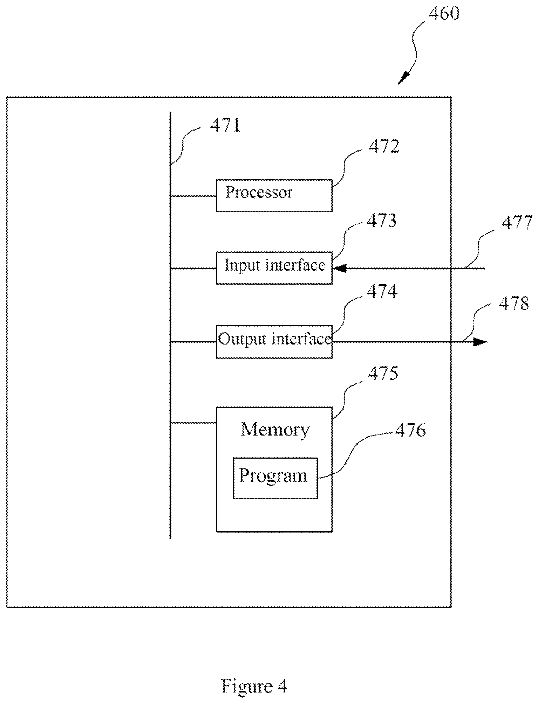

The reflow soldering furnace further comprises at least one infrared temperature measurement device 110 for detecting the temperature of the circuit board when the processed component 113 (i.e., the circuit board) is transported by the conveying device 118 to a certain defined position within the furnace chamber 106 and providing temperature data to the controller 460 (see Fig. 4). As an example, the at least one temperature measurement device 110 comprises a plurality of infrared temperature measurement devices configured to detect the temperature of the circuit board at two or more independent positions in the plurality of processing zones of the furnace chamber 106. In the present example, the infrared temperature measurement device 110 is disposed between two adjacent processing units 107 to detect the temperature of the circuit board at the position between the two adjacent processing units 107. As an example, an infrared temperature measurement device 110 may be provided between every two adjacent processing units 107.

Based on the temperature data detected and provided by the individual infrared temperature measurement devices 110, the controller 460 is capable of providing closed-loop control of the temperature of the individual processing units 107 of the reflow soldering furnace As an example, the closed-loop control may comprise control methods for controlling the power of the heating element and/or cooling element, the conveying speed of the conveying device, etc. Specifically, the controller 460 is configured to compare the temperature data of the circuit board detected by the infrared temperature measurement device 110 with the preset temperature value of the corresponding processing unit 107 and to perform closed-loop control of the temperature of the corresponding processing unit 107 based on the result of the comparison.

It may be understood by those skilled in the art that although the temperature measurement device shown in the present example is used for the temperature detection of circuit boards in a reflow soldering furnace, in other examples the infrared temperature measurement device can also be used for the temperature detection of processed components such as photovoltaic devices or circuit boards in furnaces such as sintering furnaces and wave soldering furnaces. Depending on the specific type of processing furnace, an infrared temperature measurement device may be provided at different positions to detect the temperature of the processed component at the desired position.

In general, the infrared temperature measurement device 110 needs to be periodically calibrated to establish, maintain, and demonstrate the metrological traceability of the infrared temperature measurement device 110, improve the deviation and uncertainty between the measurements and reference values of the infrared temperature measurement device 110, improve the reliability of the infrared temperature measurement device 110, and determine whether there has been a change in the performance of the infrared temperature measurement device 110 which may cause doubts about the accuracy of previously produced results.

Some existing calibration devices are disposed on the outside of the processing furnace 100, and when calibrating the infrared temperature measurement device 110, the infrared temperature measurement device 110 needs to be disassembled from the processing furnace 100 before the infrared temperature measurement device 110 can be calibrated. Reinstallation of the infrared temperature measurement device 110 after calibration requires readjustment of the position, software parameters, etc.

In the present application, the calibration device is disposed inside the processing furnace 100, and the infrared temperature measurement device 110 can be calibrated without disassembling the infrared temperature measurement device 110.

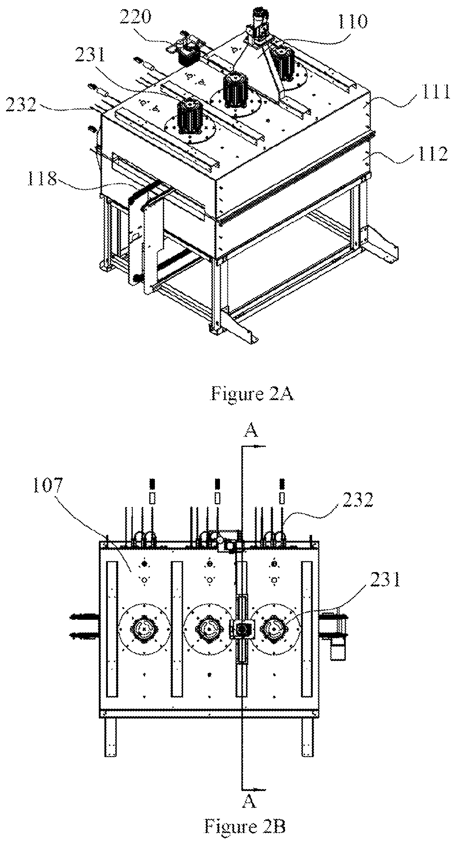

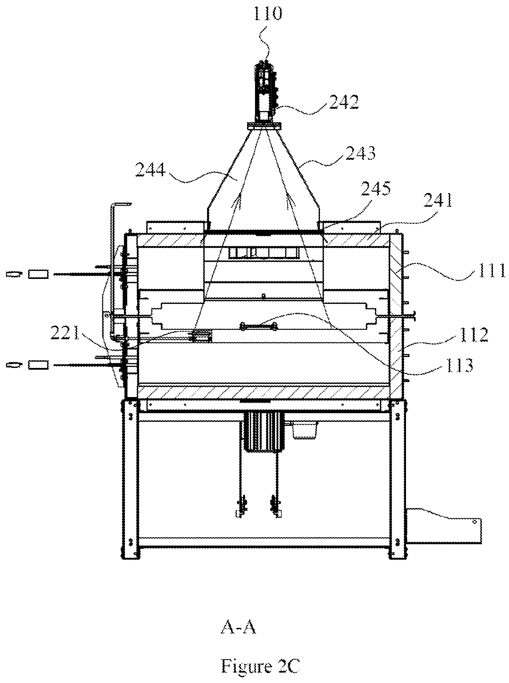

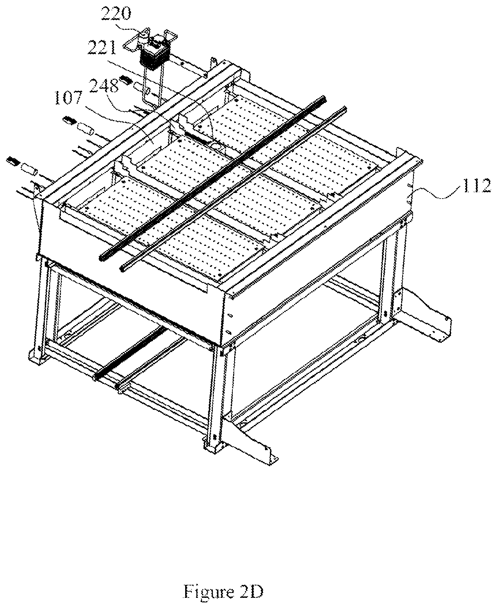

Fig. 2A - Fig. 2D show the specific structure of three processing units 107 side by side in the processing furnace 100 shown in Fig. 1. Fig. 2A is a three-dimensional structural diagram of the three processing units 107 side by side in the processing furnace 100, Fig. 2B is a top view of Fig. 2A, Fig. 2C is a cross-sectional view of Fig. 2B along the A-A line, and Fig. 2D is a three-dimensional structural diagram of the three processing units 107 shown in Fig. 2A with the upper furnace chamber 111 omitted. In the present example, the processing units in the preheating zone 101 and the peak zone 103 are taken as examples for illustration. As shown in Fig. 2A - Fig. 2D, three processing units 107 are arranged side by side, and the air in each processing unit 107 is heated to different temperatures by the heating element 232. Each processing unit 107 comprises a set of fans 231 that are separately connected to the upper furnace chamber 111 and lower furnace chamber 112. The circulation of gas through the interior of each processing unit 107, driven by the fans 231, enables a uniform temperature of the gas in each processing unit 107, so as to evenly heat the processed component 113 passing through the processing units 107.

The infrared temperature measurement device 110 is connected to the top wall 241 of the furnace chamber 106 and is disposed between two adjacent processing units 107 to detect the temperature of the processed component 113 as the conveying device 118 conveys the processed component 113 away from one processing unit 107 and into the next adjacent processing unit 107. Specifically, the top wall 241 of the furnace chamber 106 is provided with at least one furnace chamber top opening 245 that is substantially a rectangular opening, and the number of furnace chamber top openings 245 corresponds to the number of infrared temperature measurement devices 110. The infrared temperature measurement device 110 comprises an infrared camera 242 and a hollow support shroud 243 that encircles the furnace chamber top opening 245 and is supported above the top wall 241 of the furnace chamber 106. The support shroud 243 has a shroud cavity 244 in it which is fluidly connected to the interior of the furnace chamber 106 through the furnace chamber top opening 245. The infrared camera 242 is mounted above the support shroud 243 to provide a detection field of view of the infrared camera 242 toward the inside of the furnace chamber 106 through the shroud cavity 244 and the furnace chamber top opening 245, so as to detect the temperature of the processed component 113 in the furnace chamber 106. The infrared camera 242 receives the infrared radiation from the processed component 113 in the furnace chamber 106 through the detection field of view and thus obtains the temperature of the processed component 113. In the present example, the infrared camera 242 is a linear scanning infrared camera. When the processed component 113 is conveyed along the length of the furnace chamber 106 by the conveying device 118, the infrared radiation of the processed component 113 in each width direction perpendicular to the length is scanned to obtain the temperature of the processed component 113 in each width direction along the length, thereby obtaining the detected temperature data of the processed component 113.

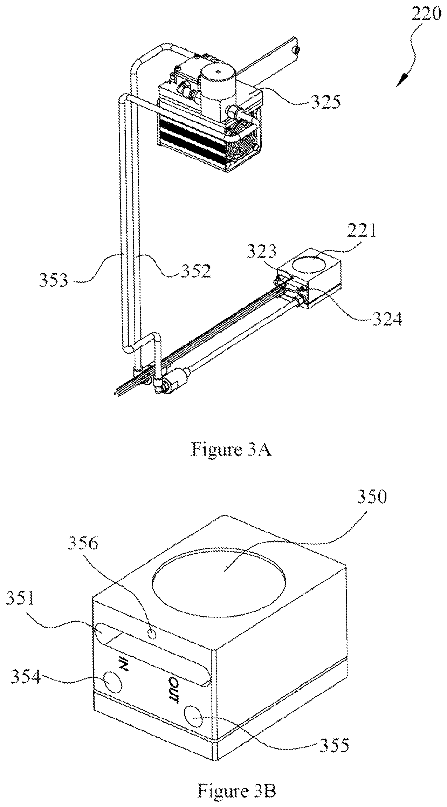

The calibration device 220 comprises a black body module 221, a heating module 324, and a cooling module 325 (see Fig. 3A). The heating module 324 and cooling module 325 are used to enable the black body module 221 to reach a predetermined standard temperature. The black body module 221 is disposed in the furnace chamber 106 and is located in the detection field of view of the infrared camera 242 to enable the infrared camera 242 to detect the temperature of the black body module 221 and obtain calibration temperature data of the black body module 221. The black body module 221 is disposed below the corresponding infrared temperature measurement device 110. In the present example, the black body module 221 is disposed between two adjacent processing units 107, corresponding to the infrared temperature measurement device 110. As a specific example, there is a divider 248 between adjacent processing units 107 for isolating gas flow inside each processing unit 107. The black body module 221 is disposed at the divider 248 to prevent the interference of the black body module 221 by the gas inside the processing units 107. In addition, the infrared temperature measurement device 110 is correspondingly disposed between adjacent processing units 107 to detect the temperature of the black body module 221.

Also, the black body module 221 is disposed between the upper furnace chamber 111 and lower furnace chamber 112, close to the position of the processed component 113, such that the distance of the infrared camera 242 from the black body module 221 is approximately the same as that from the processed component 113, thus reducing the interference of the distance between the infrared camera 242 and the black body module 221 on the accuracy of the calibration. As an example, the black body module 221 is connected to the top of the lower furnace chamber 112 and located below the conveying device 118.

After the infrared camera 242 of the infrared temperature measurement device 110 has been used for a period of time, the infrared camera 242 needs to undergo calibration or compensation. Based on the temperature measurement range and accuracy requirements of the infrared temperature measurement device 110, the temperature data of the black body module 221 of the calibration device 220 may be set to a plurality of preset standard temperature values, and a plurality of detected temperature values corresponding to the standard temperature values and detected by the infrared camera 242 may be obtained. By fitting the standard temperature values and the detected temperature values into a curve, the infrared camera 242 may be calibrated according to the fitted curve.

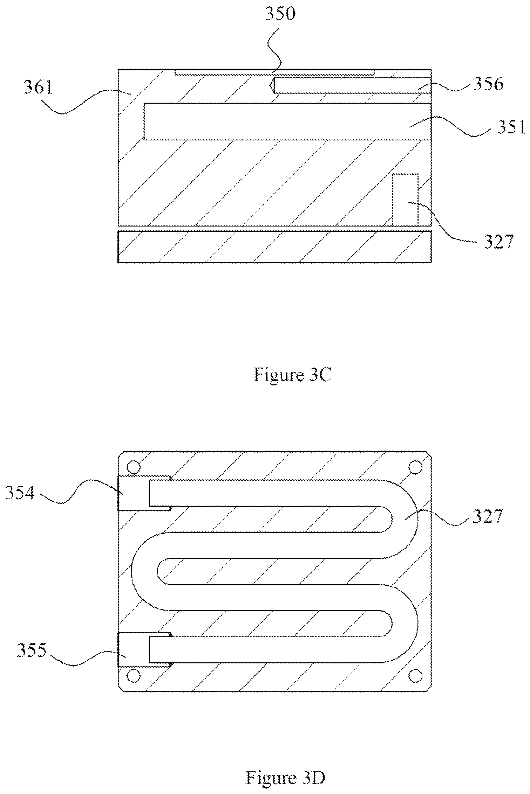

Fig. 3A - Fig. 3D illustrate the specific structure of the calibration device 220. Fig. 3A is a three-dimensional structural diagram of the calibration device 220, Fig. 3B is a three-dimensional structural diagram of the black body module 221, and Fig. 3C and Fig. 3D are cross-sectional views of the black body module 221 in two directions. As shown in Fig. 3A - Fig. 3D, the black body module 221 comprises a casing 361 and a black body portion 350, wherein the casing 361 is substantially square in shape and the black body portion 350 is disposed on the top surface of the casing 361. The black body portion 350 is made of a black body that is capable of absorbing all external electromagnetic radiation without any reflection or transmission.

In the present example, the heating module 324 of the calibration device 220 is a heating rod that extends outside of the furnace chamber 106 (shown in conjunction with Fig. 2A and Fig. 2D) such that it is communicatively connected to the controller 460 (see Fig. 4). The casing 361 is provided with a slot 351, and the heating rod extends into the slot 351 to heat the black body portion 350 on the black body module 221. In the present example, in order to heat the black body portion 350 more uniformly, the slot 351 is disposed below the black body 350 and extends through the black body portion 350 inside the casing 361 such that the heating module 324 extends into the slot 351 and through the black body portion 350.

In the present example, the cooling module 325 of the calibration device 220 is a semiconductor cooling module, such as a Peltier semiconductor cooler, which is capable of having lower extreme cooling temperatures than other coolers. The cooling module 325 also extends to the outside of the furnace chamber 106 (shown in conjunction with Fig. 2A and Fig. 2D) such that it is communicatively connected to the controller 460 (see Fig. 4). The cooling module 325 has a cooling gas inlet tube 352 and a cooling gas outlet tube 353. Cooling gas obtained from the cooling by the Peltier semiconductor cooler may flow out through the cooling gas inlet tube 352 and, after flowing through the casing 361, return to the Peltier semiconductor cooler through the cooling gas outlet tube 353 and be cooled again to complete the circulation of gas. The casing 361 has a cooling gas channel 327 with a tortuous shape that has a channel inlet 354 and a channel outlet 355, wherein the cooling gas inlet tube 352 is fluidly connected to the channel inlet 354 and the cooling gas outlet tube 353 is fluidly connected to the channel outlet 355 such that the cooling gas obtained by the cooling from the Peltier semiconductor cooler can flow through the cooling gas channel 327 in the casing 361 and back to the Peltier semiconductor cooler. In order to cool the black body portion 350 more uniformly, the cooling gas channel 327 is disposed below the black body portion 350 and extends tortuously through the black body portion 350 within the casing 361.

The calibration device 220 also includes a temperature sensor 323 for measuring the temperature of the black body portion 350 and providing the standard temperature data of the black body portion 350. The temperature sensor 323 also extends to the outside of the furnace chamber 106 (shown in conjunction with Fig. 2A and Fig. 2D) such that it is communicatively connected to the controller 460 (see Fig. 4). In the present example, the temperature sensor 323 is a resistance temperature detector, such as a PT100 temperature sensor, and is capable of accurately obtaining the standard temperature of the black body portion 350. The casing 361 has an aperture 356 within it that is disposed below the black body portion 350 and close to the black body portion 350. The temperature sensor 323 is inserted into the aperture 356 to detect the temperature of the black body portion 350. As a more specific example, the temperature sensor 323 is capable of detecting the temperature at the central position of the black body portion 350.

Fig. 3C is a longitudinal cross-sectional view of the casing 361 of the black body module 221 through the center of the aperture 356, and Fig. 3D is a transverse cross-sectional view of the casing 361 of the black body module 221 through the channel inlet 354 and the channel outlet 355. With further reference to Fig. 3C and Fig. 3D, the aperture 356, slot 351, and cooling gas channel 327 are all disposed within the casing 361 and located sequentially below the black body portion 350 from top to bottom. That is, the temperature sensor 323 is closest to the black body portion 350, so the temperature sensor 323 is capable of detecting the temperature of the black body portion 350 most directly. In addition, the depth of the aperture 356 is less than the depth of the slot 351, that is, the temperature sensor 323 extends into the center of the black body portion 350 in the aperture 356, and the heating rod extends into the slot 351 and passes through the black body portion 350. Also, the cooling gas channel 327 is of a tortuous shape and passes through the black body portion 350 in both the directions of the length and the width.

As such, the black body portion 350 of the black body module 221 may be heated by the heating module 324 to increase the temperature of the black body portion 350, or may be cooled by the cooling module 325 to decrease the temperature of the black body portion 350. In addition, the black body portion 350 of the black body module 221 may be detected by the temperature sensor 323 to obtain a standard temperature.

When the processing furnace 100 is in operation, the conveying device 118 conveys the processed component 113 through the furnace chamber 106. While the heating module 324 and the cooling module 325 of the black body module 221 are not in operation at this time, the black body module 221 may still provide standard temperature data through the temperature sensor 323. The infrared camera 242 detects the temperature of the corresponding black body module 221 to obtain calibration temperature data, and by comparing the standard temperature data and calibration temperature data of the same black body module 221, it may be determined whether the infrared camera 242 needs to be shut down and calibrated.

When the processing furnace 100 stops operation, the black body module 221 is heated or cooled to various preset temperatures by the heating module 324 and the cooling module 325 to provide a plurality of preset standard temperature data, and the infrared camera 242 detects the temperature of the black body module 221 to obtain the corresponding calibration temperature data, which allows the infrared camera 242 of the infrared temperature measurement device 110 to be calibrated according to the standard temperature data and calibration data.

Fig. 4 is a schematic block diagram of the controller 460. As shown in Fig. 4, the controller 460 comprises a bus 471, a processor 472, an input interface 473, an output interface 474, and a memory 475 with a control program 476. The various components of the controller 460, comprising the processor 472, the input interface 473, the output interface 474, and the memory 475, are communicatively connected to the bus 471 such that the processor 472 is capable of controlling the operation of the input interface 473, the output interface 474, and the memory 475. Specifically, the memory 475 is used to store programs, instructions, and data, while the processor 472 reads programs, instructions, and data from the memory 475 and is capable of writing data to the memory 475. By executing the programs and instructions read from the memory 475, the processor 472 controls the operation of the input interface 473 and the output interface 474.

As shown in Fig. 4, the input interface 473 is communicatively connected to the infrared temperature measurement device 110 and a display device (not shown in the figure) via a connection 477 to receive the detected temperature data and calibration temperature data provided by the infrared temperature measurement device 110 and the control instructions received by the display device, and to store the detected temperature data and control instructions in memory 475.

In addition, the input interface 473 is also communicatively connected to the temperature sensor 323 of the calibration device 220 via the connection 477 to receive the standard temperature data provided by the calibration device 220 and to store the standard temperature data in the memory 475. The output interface 474 is also communicatively connected with the infrared temperature measurement device 110 through a connection 478. By executing the program 476 in the memory 475 and the received control instructions, the controller 460 is also capable of calibrating the infrared temperature measurement device 110.

The output interface 474 is communicatively connected with the heating element in the furnace chamber 106 of the processing furnace 100, the conveying device 118, and the heating module 324 and the cooling module 325 of the calibration device 220 via the connection 478. By executing the program 476 and the received instructions in the memory 475, the controller 460 provides closed-loop control of the temperature of the various processing zones in the furnace chamber 106 and is capable of adjusting the temperature of the black body module 221 of the calibration device 220.

In existing processing furnaces, gas temperatures in various processing zones of the furnace chamber are generally detected by thermal probes, and the settings of the processing furnace are modified as needed by an intelligent software, so as to maintain the temperature within various processing zones within the specified range, thereby ensuring the processing yield of the processed component in the processing furnace.

In the present application, the infrared temperature measurement device directly detects the temperature of the processed component in the processing furnace instead of detecting the temperature of the gas in the processing furnace, which enables for more direct control of the amount of heat or cold absorbed by the processed component in the various processing zones of the processing furnace, thereby improving the yield of the product.

In addition, in the present application, the calibration device for calibrating the infrared temperature measurement device is disposed within the processing furnace such that the infrared camera does not need to be disassembled when the infrared temperature measurement device is calibrated, and therefore it is not necessary to readjust the mounting position of the infrared camera after calibration is completed. The calibration process is not only convenient and easy to implement but also prevents errors caused by repeated disassembly and assembly of the infrared camera.

Although the present disclosure has been described in conjunction with the examples of examples outlined above, various alternatives, modifications, variations, improvements, and/or substantial equivalents, whether known or foreseeable now or in the near future, may be apparent to those having at least ordinary skill in the art. In addition, the technical effects and/or technical problems described in the present Specification are exemplary and not limiting; therefore, the disclosure in the present Specification may be used to solve other technical problems and have other technical effects and/or may solve other technical problems. Therefore, the examples of embodiments of the present disclosure as set forth above are intended to be illustrative and not limiting.

## Claims

1. A reflow soldering furnace comprising:
a furnace chamber (106);
at least one infrared temperature measurement device (110) that is connected to the furnace chamber (106) and configured to have a detection field of view towards the furnace chamber (106) to detect the temperature of a circuit board within the furnace chamber (106);
at least one calibration device (220) that is provided corresponding to the at least one temperature measurement device (110) and is connected to the furnace chamber (106), with the calibration device (220) comprising a black body module (221) having a standard temperature that is connected to the detection field of view of the corresponding infrared temperature measurement device (110) and is capable of providing standard temperature data; and
a controller (460) that is communicatively connected to the infrared temperature measurement device (110) and the calibration device (220);
wherein the infrared temperature measurement device (110) is configured to be capable of detecting the temperature of the black body module (221) in the corresponding calibration device (220) and obtaining calibration temperature data, and the controller (460) is configured to calibrate the infrared temperature measurement device (110) according to the standard temperature data and the calibration temperature data;
the calibration device (220) further comprises a temperature sensor (323) configured to provide the standard temperature of the black body module (221);
the calibration device (220) further comprises a heating module (324) and a cooling module (325), wherein the heating module (324) is configured to increase the temperature of the black body module (221) and the cooling module (325) is configured to reduce the temperature of the black body module (221).

2. The reflow soldering furnace according to Claim 1, wherein:
the furnace chamber (106) comprises a plurality of processing zones (101, 103, 105);
the reflow soldering furnace (100) further comprises a conveying device (118) disposed within the furnace chamber (106) and extending in the conveying direction, with the conveying device (118) configured to carry the circuit board (113) through the plurality of processing zones (101, 103, 105) of the furnace chamber (106);
the infrared temperature measurement device (110) is configured to detect the temperature of the circuit board (113) in the furnace chamber (106) and provide detected temperature data;
wherein the controller (460) is configured to receive the detected temperature data provided by the infrared temperature measurement device (110).

3. The reflow soldering furnace according to Claim 2, wherein:
the at least one infrared temperature measurement device (110) comprises a plurality of infrared temperature measurement devices (110) configured to detect the temperature of the circuit board (113) at two or more independent locations in the plurality of processing zones (101, 103, 105) in the furnace chamber (106).

4. The reflow soldering furnace according to Claim 2, wherein:
the furnace chamber (106) comprises an upper furnace chamber (111) and a lower furnace chamber (112), and the conveying device (118) extends between the upper furnace chamber (111) and the lower furnace chamber (112);
wherein the black body module (221) is connected to the top of the lower furnace chamber (112).

5. The reflow soldering furnace according to Claim 2, wherein:
the plurality of processing zones (101, 103, 105) comprise a plurality of processing units (107) arranged side by side, with the black body module (221) connected between two adjacent processing units (107) of the plurality of processing units (107).

6. The reflow soldering furnace according to Claim 1, wherein:
the temperature sensor (323) is a resistance temperature detector.

7. The reflow soldering furnace according to Claim 1, wherein:
The black body module (221) comprises a cooling gas channel (327) with a tortuous shape that is fluidly connected with the cooling module (325), wherein the cooling module (325) is configured such that cooling gas flows through the cooling gas channel (327) to reduce the temperature of the black body module (221).

8. The reflow soldering furnace according to Claim 1, wherein:
the top wall (241) of the furnace chamber (106) has at least one furnace chamber top opening (245);
each of the infrared temperature measurement devices (110) comprise an infrared camera (242) and a support shroud (243), with the infrared camera (242) mounted to the support shroud (243);
wherein the support shroud (243) encircles the furnace chamber top opening (245) and is supported on the top wall (241) to provide the detection field of view toward the inside of the furnace chamber (106) through the corresponding furnace chamber top opening (245).

## Patentansprüche

1. Reflow-Lötofen, aufweisend:
eine Ofenkammer (106);
mindestens eine Infrarottemperaturmessvorrichtung (110), die mit der Ofenkammer (106) verbunden ist und eingerichtet ist, ein Erfassungssichtfeld in Richtung der Ofenkammer (106) zu haben, um die Temperatur einer Leiterplatte innerhalb der Ofenkammer (106) zu erfassen;
mindestens eine Kalibriervorrichtung (220), die entsprechend der mindestens einen Temperaturmessvorrichtung (110) vorgesehen ist und mit der Ofenkammer (106) verbunden ist, wobei die Kalibriervorrichtung (220) ein Schwarzkörpermodul (221) mit einer Standardtemperatur aufweist, das mit dem Erfassungssichtfeld der entsprechenden Infrarottemperaturmessvorrichtung (110) verbunden ist und in der Lage ist, Standardtemperaturdaten bereitzustellen; und
eine Steuerung (460), die kommunikativ mit der Infrarottemperaturmessvorrichtung (110) und der Kalibriervorrichtung (220) verbunden ist;
wobei die Infrarottemperaturmessvorrichtung (110) eingerichtet ist, die Temperatur des Schwarzkörpermoduls (221) in der entsprechenden Kalibriervorrichtung (220) zu erfassen und Kalibriertemperaturdaten zu erhalten, und die Steuerung (460) eingerichtet ist, die Infrarottemperaturmessvorrichtung (110) gemäß den Standardtemperaturdaten und den Kalibriertemperaturdaten zu kalibrieren;
wobei die Kalibriervorrichtung (220) ferner einen Temperatursensor (323) aufweist, der eingerichtet ist, die Standardtemperatur des Schwarzkörpermoduls (221) bereitzustellen;
wobei die Kalibriervorrichtung (220) ferner ein Heizmodul (324) und ein Kühlmodul (325) aufweist, wobei das Heizmodul (324) eingerichtet ist, die Temperatur des Schwarzkörpermoduls (221) zu erhöhen, und das Kühlmodul (325) eingerichtet ist, die Temperatur des Schwarzkörpermoduls (221) zu verringern.

2. Reflow-Lötofen nach Anspruch 1, wobei:
die Ofenkammer (106) eine Vielzahl von Verarbeitungszonen (101, 103, 105) aufweist;
der Reflow-Lötofen (100) ferner eine Fördervorrichtung (118) aufweist, die innerhalb der Ofenkammer (106) angeordnet ist und sich in der Förderrichtung erstreckt, wobei die Fördervorrichtung (118) eingerichtet ist, die Leiterplatte (113) durch die Vielzahl von Verarbeitungszonen (101, 103, 105) der Ofenkammer (106) zu transportieren;
die Infrarottemperaturmessvorrichtung (110) so eingerichtet ist, dass sie die Temperatur der Leiterplatte (113) in der Ofenkammer (106) erfasst und erfasste Temperaturdaten bereitstellt;
wobei die Steuerung (460) eingerichtet ist, die erfassten Temperaturdaten, die von der Infrarottemperaturmessvorrichtung (110) bereitgestellt werden, zu empfangen.

3. Reflow-Lötofen nach Anspruch 2, wobei:
die mindestens eine Infrarottemperaturmessvorrichtung (110) eine Vielzahl von Infrarottemperaturmessvorrichtungen (110) aufweist, die eingerichtet sind, die Temperatur der Leiterplatte (113) an zwei oder mehr unabhängigen Orten in der Vielzahl von Verarbeitungszonen (101, 103, 105) in der Ofenkammer (106) zu erfassen.

4. Reflow-Lötofen nach Anspruch 2, wobei:
die Ofenkammer (106) eine obere Ofenkammer (111) und eine untere Ofenkammer (112) aufweist, und die Fördervorrichtung (118) sich zwischen der oberen Ofenkammer (111) und der unteren Ofenkammer (112) erstreckt;
wobei das Schwarzkörpermodul (221) mit der Oberseite der unteren Ofenkammer (112) verbunden ist.

5. Reflow-Lötofen nach Anspruch 2, wobei:
die Vielzahl von Verarbeitungszonen (101, 103, 105) eine Vielzahl von nebeneinander angeordneten Verarbeitungseinheiten (107) aufweist, wobei das Schwarzkörpermodul (221) zwischen zwei benachbarten Verarbeitungseinheiten (107) der Vielzahl von Verarbeitungseinheiten (107) angeschlossen ist.

6. Reflow-Lötofen nach Anspruch 1, wobei:
der Temperatursensor (323) ein Widerstandstemperaturdetektor ist.

7. Reflow-Lötofen nach Anspruch 1, wobei:
das Schwarzkörpermodul (221) einen mit dem Kühlmodul (325) fluidisch verbundenen Kühlgaskanal (327) mit gewundener Form aufweist, wobei das Kühlmodul (325) derart ausgestaltet ist, dass der Kühlgaskanal (327) zur Absenkung der Temperatur des Schwarzkörpermoduls (221) von Kühlgas durchströmt wird.

8. Reflow-Lötofen nach Anspruch 1, wobei:
die obere Wand (241) der Ofenkammer (106) mindestens eine obere Ofenkammeröffnung (245) aufweist;
jede der Infrarottemperaturmessvorrichtungen (110) eine Infrarotkamera (242) und eine Stützummantelung (243) aufweist, wobei die Infrarotkamera (242) an der Stützummantelung (243) montiert ist;
wobei die Stützummantelung (243) die obere Ofenkammeröffnung (245) umgibt und an der oberen Wand (241) abgestützt ist, um das Erfassungssichtfeld zum Inneren der Ofenkammer (106) durch die entsprechende obere Ofenkammeröffnung (245) bereitzustellen.

## Revendications

1. Four de soudage par refusion comprenant :
une chambre de four (106) ;
l'au moins un dispositif de mesure de température infrarouge (110) qui est connecté à la chambre de four (106) et configuré pour avoir un champ de vision de détection vers la chambre de four (106) afin de détecter la température d'une carte de circuit à l'intérieur de la chambre de four (106) ;
l'au moins un dispositif d'étalonnage (220) qui est fourni correspondant à l'au moins un dispositif de mesure de température (110) et est connecté à la chambre de four (106), le dispositif d'étalonnage (220) comprenant un module de corps noir (221) ayant une température standard qui est connecté au champ de vision de détection du dispositif de mesure de température infrarouge correspondant (110) et est capable de fournir des données de température standard ; et
un dispositif de commande (460) qui est connecté de manière communicative au dispositif de mesure de température infrarouge (110) et au dispositif d'étalonnage (220) ;
dans lequel le dispositif de mesure de température infrarouge (110) est configuré pour être capable de détecter la température du module de corps noir (221) dans le dispositif d'étalonnage correspondant (220) et d'obtenir des données de température d'étalonnage, et le dispositif de commande (460) est configuré pour étalonner le dispositif de mesure de température infrarouge (110) selon les données de température standard et les données de température d'étalonnage ;
le dispositif d'étalonnage (220) comprend en outre un capteur de température (323) configuré pour fournir la température standard du module de corps noir (221) ;
le dispositif d'étalonnage (220) comprend en outre un module de chauffage (324) et un module de refroidissement (325), dans lequel le module de chauffage (324) est configuré pour augmenter la température du module de corps noir (221) et le module de refroidissement (325) est configuré pour réduire la température du module de corps noir (221).

2. Four de soudage par refusion selon la revendication 1, dans lequel :
la chambre de four (106) comprend une pluralité de zones de traitement (101, 103, 105) ;
le four de soudage par refusion (100) comprend en outre un dispositif de transport (118) disposé à l'intérieur de la chambre de four (106) et s'étendant dans la direction de transport, le dispositif de transport (118) étant configuré pour transporter la carte de circuit (113) à travers la pluralité de zones de traitement (101, 103, 105) de la chambre de four (106) ;
le dispositif de mesure de température infrarouge (110) est configuré pour détecter la température de la carte de circuit (113) dans la chambre de four (106) et fournir des données de température détectées ;
dans lequel le dispositif de commande (460) est configuré pour recevoir les données de température détectées fournies par le dispositif de mesure de température infrarouge (110).

3. Four de soudage par refusion selon la revendication 2, dans lequel :
l'au moins un dispositif de mesure de température infrarouge (110) comprend une pluralité de dispositifs de mesure de température infrarouge (110) configurés pour détecter la température de la carte de circuit (113) au niveau de deux emplacements indépendants ou plus dans la pluralité de zones de traitement (101, 103, 105) dans la chambre de four (106).

4. Four de soudage par refusion selon la revendication 2, dans lequel :
la chambre de four (106) comprend une chambre de four supérieure (111) et une chambre de four inférieure (112), et le dispositif de transport (118) s'étend entre la chambre de four supérieure (111) et la chambre de four inférieure (112) ;
dans lequel le module de corps noir (221) est connecté au sommet de la chambre de four inférieure (112).

5. Four de soudage par refusion selon la revendication 2, dans lequel :
la pluralité de zones de traitement (101, 103, 105) comprend une pluralité d'unités de traitement (107) agencées côte à côte, le module de corps noir (221) étant connecté entre deux unités de traitement adjacentes (107) de la pluralité d'unités de traitement (107).

6. Four de soudage par refusion selon la revendication 1, dans lequel :
le capteur de température (323) est un détecteur de température à résistance.

7. Four de soudage par refusion selon la revendication 1, dans lequel :
Le module de corps noir (221) comprend un canal de gaz de refroidissement (327) présentant une forme tortueuse qui est en communication fluidique avec le module de refroidissement (325), le module de refroidissement (325) étant configuré de sorte que le gaz de refroidissement s'écoule à travers le canal de gaz de refroidissement (327) pour réduire la température du module de corps noir (221).

8. Four de soudage par refusion selon la revendication 1, dans lequel :
la paroi supérieure (241) de la chambre de four (106) a l'au moins une ouverture supérieure de chambre de four (245) ;
chacun des dispositifs de mesure de température infrarouge (110) comprend une caméra infrarouge (242) et une enveloppe de support (243), la caméra infrarouge (242) étant montée sur l'enveloppe de support (243) ;
dans lequel l'enveloppe de support (243) entoure l'ouverture supérieure de la chambre du four (245) et est supportée sur la paroi supérieure (241) pour fournir le champ de vision de détection vers l'intérieur de la chambre du four (106) à travers l'ouverture supérieure correspondante de la chambre du four (245).
